# DEMANDE DE BREVET EUROPEEN

(11) **EP 1 048 955 A1**
(43) Date de publication de la demande: **02.11.2000**
(21) Numéro de dépôt: 00401169.8
(22) Date de dépôt: 27.04.2000
(51) Int. Cl.: G01R 31/04

(54) **Dispositif de test pour câble équipé d'un accessoire de câblage à l'une de ses extrémités**

(30) Priorité: 29.04.1999 FR 9905436
(71) Demandeur: LEGRAND, F-87000 Limoges (FR); LEGRAND SNC, F-87000 Limoges (FR)
(72) Inventeur: Baillet, Alain, 76710 Montville (FR); Bouteiller, Pascal, 76160 Darnetal (FR)
(74) Mandataire: CABINET BONNET-THIRION

(57) **Abrégé**

Il s'agit de contrôler le sertissage d'un accessoire de câblage (11) à l'extrémité d'un câble électrique (10).

Suivant l'invention, le dispositif de test (18) mis en oeuvre à cet effet comporte au moins un trou (19), qui est propre à un engagement du câble électrique (10) par l'extrémité de celui-ci opposée à celle à laquelle intervient l'accessoire de câblage (11), et dans lequel interfère latéralement au moins un élément escamotable (20) formant butée pour cet accessoire de câblage (11) et susceptible de céder sous une force de traction (F) donnée.

Application, notamment, aux embouts de câblage.

## Description

La présente invention concerne d'une manière générale les accessoires de câblage qu'il est usuel de rapporter à l'une des extrémités d'un câble électrique pour en faciliter l'engagement dans une quelconque borne de connexion aussi bien que pour rendre plus fiable et plus sûre la connexion correspondante.

Elle vise plus particulièrement, mais non nécessairement exclusivement, le cas où un tel accessoire de câblage, alors plus communément appelé embout de câblage, comporte, d'une part, une partie métallique, en forme de manchon, qui est destinée à être sertie sur l'extrémité, au préalable dénudée, de l'âme conductrice du câble électrique à équiper, et, d'autre part, une partie isolante, en forme de douille, qui, solidaire de la partie métallique, est destinée, elle, à s'engager sur la gaine isolante de ce câble électrique, pour recouvrir l'extrémité de cette dernière et reconstituer ainsi à ce niveau toute l'isolation souhaitable.

Il importe, bien entendu, que le sertissage de la partie métallique, qui est assuré mécaniquement, à l'aide par exemple d'une pince de sertissage, soit suffisamment ferme pour garantir une fixation efficace de l'ensemble sur le câble électrique.

Or, pour satisfaire les dispositions normatives en la matière, il est nécessaire de pouvoir contrôler cette fixation.

A ce jour, ce contrôle, qui, bien entendu, intervient par échantillonnage, se fait en atelier, voire en laboratoire, à l'aide d'une machine de traction spécifique.

Un tel contrôle est donc inévitablement différé par rapport à l'utilisation propre de la pince de sertissage correspondante sur le chantier, et, tout aussi inévitablement, il est relativement coûteux.

La présente invention a d'une manière générale pour objet un dispositif de test permettant au contraire d'exécuter sans retard sur le chantier même, et aux moindres frais, le contrôle à assurer.

Ce dispositif de test, qui est donc destiné au contrôle d'un câble électrique équipé d'un accessoire de câblage à l'une de ses extrémités, est d'une manière générale caractérisé en ce qu'il comporte au moins un trou, qui est propre à un engagement du câble électrique par l'extrémité de celui-ci opposée à celle à laquelle intervient l'accessoire de câblage, et dans lequel interfère latéralement au moins un élément escamotable formant butée pour cet accessoire de câblage et susceptible de céder sous une force de traction donnée.

Par exemple, suivant une forme préférée de réalisation, cet élément escamotable s'étend sur une partie au moins du pourtour du trou, et, plus préférentiellement encore, sur la totalité de ce pourtour, en formant alors un oeillet, et il est relié à la paroi latérale du trou par au moins une attache sécable.

Quoi qu'il en soit, il suffit, sur le chantier, à l'opérateur qui veut s'assurer du bon fonctionnement de sa pince de sertissage, d'engager dans le trou du dispositif de test à sa disposition un câble électrique équipé d'un accessoire de câblage jusqu'à la butée de cet accessoire de câblage contre l'élément escamotable interférant dans ce trou, et de tirer avec une force suffisante sur ce câble électrique : si l'accessoire de câblage se détache du câble électrique, c'est, à l'évidence, que le sertissage de sa partie métallique sur l'âme conductrice de celui-ci est défectueux ; au contraire, si c'est l'élément escamotable du dispositif de test qui cède, en laissant alors un libre passage au câble électrique à travers le dispositif de test, ce sertissage est satisfaisant.

En pratique, le dispositif de test suivant l'invention peut avantageusement se présenter sous la forme d'une plaquette, que le ou les trous qu'il comporte traversent transversalement de part en part, et qui peut très simplement et très économiquement être réalisée en matière synthétique.

Eu égard à son faible coût, et à la différence des machines de traction usuellement mises en oeuvre, le dispositif de test suivant l'invention est, donc, dans ce cas, un produit consommable à jeter après usage.

Préférentiellement, cependant, pour être en mesure d'être utilisé plusieurs fois, le dispositif de test suivant l'invention comporte plusieurs trous, dont chacun est normalement susceptible de satisfaire à une seule et unique utilisation.

Par exemple, et préférentiellement, ces trous ont alors tous un même diamètre et correspondent tous à une même force de traction.

L'opérateur dispose, dans ce cas, et, par exemple, sous forme modulaire, d'un jeu de dispositifs de test différents, dont le ou les trous sont de diamètres différents et correspondent à des forces de traction différentes, en se distinguant alors par exemple les uns des autres par des couleurs différentes.

Mais, en variante, un même dispositif de test suivant l'invention peut tout aussi bien comporter par lui-même plusieurs trous de diamètres différents et correspondant à des forces de traction différentes.

Dans tous les cas, par sa forme et son faible encombrement, le dispositif de test suivant l'invention est avantageusement d'un maniement particulièrement aisé.

Les caractéristiques et avantages de l'invention ressortiront d'ailleurs de la description qui va suivre, à titre d'exemple, en référence aux dessins schématiques annexés sur lesquels :

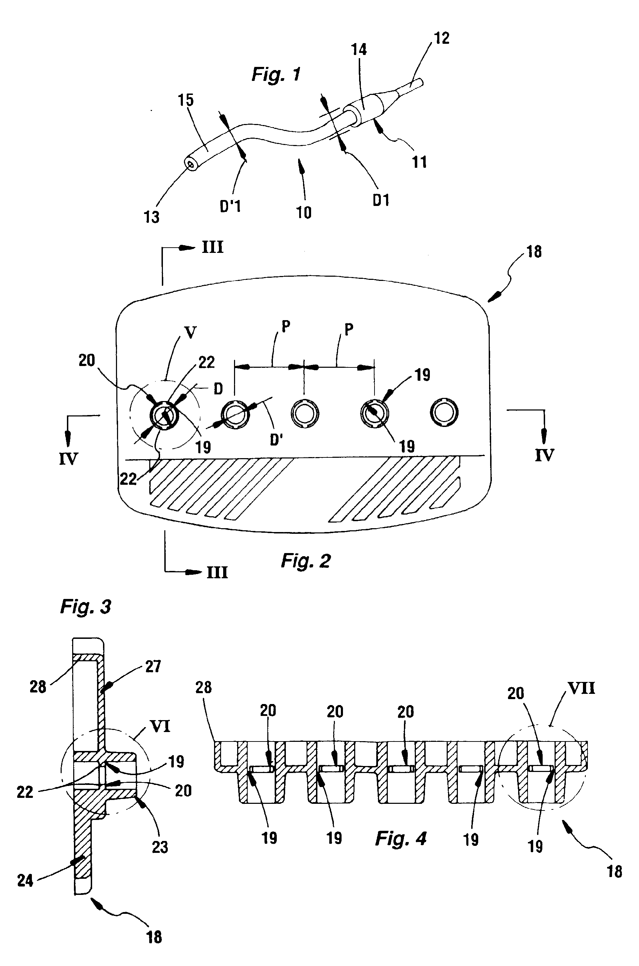

la figure 1 est une vue partielle en perspective d'un câble électrique au contrôle duquel le dispositif de test suivant l'invention est plus particulièrement destiné ;
la figure 2 est, à échelle différente, une vue en élévation de ce dispositif de test ;
la figure 3 en est une vue en coupe transversale, suivant la ligne III-III de la figure 2 ;
la figure 4 en est une vue en coupe longitudinale, suivant la ligne IV-IV de la figure 2 ;
la figure 5 reprend, à échelle supérieure, le détail de la figure 2 repéré par un encart V sur cette figure 2 ;
les figures 6 et 7 reprennent, chacune respectivement, à échelle encore supérieure, les détails des figures 3 et 4 repérés par des encarts VI et VII sur ces figures 3 et 4 ;
la figure 8 est une vue en coupe transversale qui, reprise de celle de la figure 3, illustre la mise en oeuvre du dispositif de test suivant l'invention.

Tel qu'illustré sur ces figures, il s'agit, globalement, d'assurer le contrôle d'un câble électrique 10 qui, à l'une de ses extrémités, est équipé d'un accessoire de câblage 11.

Par exemple, et tel que représenté, cet accessoire de câblage 11 est un embout de câblage.

Il comporte donc, d'une part, une partie métallique 12, qui est en forme de manchon, et par laquelle il est serti sur l'extrémité, au préalable dénudée, de l'âme conductrice 13 du câble électrique 10, et, d'autre part, une partie isolante 14, qui est en forme générale de douille, et par laquelle il est engagé sur la gaine isolante 15 du câble électrique 10, en recouvrant l'extrémité de cette dernière.

Un tel accessoire de câblage 11 étant bien connu par lui-même, et ne relevant pas en propre de la présente invention, il ne sera pas décrit plus en détail ici.

Pour le contrôle du câble électrique 10 ainsi équipé de cet accessoire de câblage 11, il est mis en oeuvre, suivant l'invention, un dispositif de test 18 comportant au moins un trou 19, qui est propre à un engagement du câble électrique 10 par l'extrémité de celui-ci opposée à celle à laquelle intervient l'accessoire de câblage 11, et dans lequel interfère, latéralement, suivant des dispositions décrites plus en détail ultérieurement, au moins un élément escamotable 20 formant butée pour cet accessoire de câblage 11 et susceptible de céder sous une force de traction F donnée.

En pratique, le trou 19 a un contour circulaire.

Soit D son diamètre.

Par construction, ce diamètre D est supérieur au diamètre extérieur D1 de la partie isolante 14 de l'accessoire de câblage 11.

Il est donc a fortiori supérieur au diamètre extérieur D'1 de la gaine isolante 15 du câble électrique 10.

Dans la forme de réalisation représentée, le dispositif de test 18 suivant l'invention se présente sous la forme générale d'une plaquette de contour globalement rectangulaire que le trou 19 qu'il comporte traverse transversalement de part en part suivant son épaisseur.

En pratique, dans cette forme de réalisation, le dispositif de test 18 suivant l'invention comporte plusieurs trous 19, de même diamètre D et correspondant tous à une même force de traction F.

Plus précisément, dans cette forme de réalisation, tous les trous 19 que comporte le dispositif de test 18 suivant l'invention ont un même diamètre D et ils correspondent tous à une même force de traction F.

Par exemple, et tel que représenté, ces trous 19 sont alignés, et ils sont établis à un pas P régulier.

Dans la forme de réalisation représentée, cinq trous 19 sont ainsi prévus, et leur alignement s'étend sensiblement parallèlement à la plus grande dimension du dispositif de test 18, sensiblement à mi-distance de l'un et l'autre des bords longitudinaux de celui-ci.

Tous les trous 19 étant identiques entre eux, seul sera décrit plus en détail dans ce qui suit l'élément escamotable 20 interférant dans l'un d'eux.

Dans la forme de réalisation représentée, cet élément escamotable 20 s'étend sur une partie au moins du pourtour du trou 19 dans lequel il interfère, et il est relié à la paroi latérale de ce trou 19 par au moins une attache sécable 22.

Préférentiellement, et cela est le cas dans la forme de réalisation représentée, cet élément escamotable 20 est un oeillet qui s'étend tout au long du pourtour du trou 19, et seul un tel élément escamotable 20 interfère alors dans ce trou 19.

En pratique, l'oeillet formant ainsi l'élément escamotable 20 a un contour circulaire, comme le trou 19, et il est coaxial de ce trou 19.

Soit D' son diamètre interne.

Par construction, il est fait en sorte que ce diamètre D' soit intermédiaire entre le diamètre D'1 de la gaine isolante 15 du câble électrique 10 et le diamètre D1 de la partie isolante 14 de l'accessoire de câblage 11.

En pratique, l'oeillet formant l'élément escamotable 20 s'étend à distance de la paroi latérale du trou 19, et, pour sa liaison détachable à cette paroi latérale, deux attaches sécables 22 sont prévues, en positions diamétralement opposées l'une par rapport à l'autre.

Chacune de ces attaches sécables 22 s'étend transversalement, et, plus précisément, radialement, par rapport au trou 19.

Dans la forme de réalisation représentée, le trou 19 est entouré par un tube de guidage 23 sur l'un au moins de ses côtés, et il est en continuité avec la surface interne de ce tube de guidage 23.

Par exemple, et tel que représenté, le tube de guidage 23 intervient de part et d'autre du trou 19.

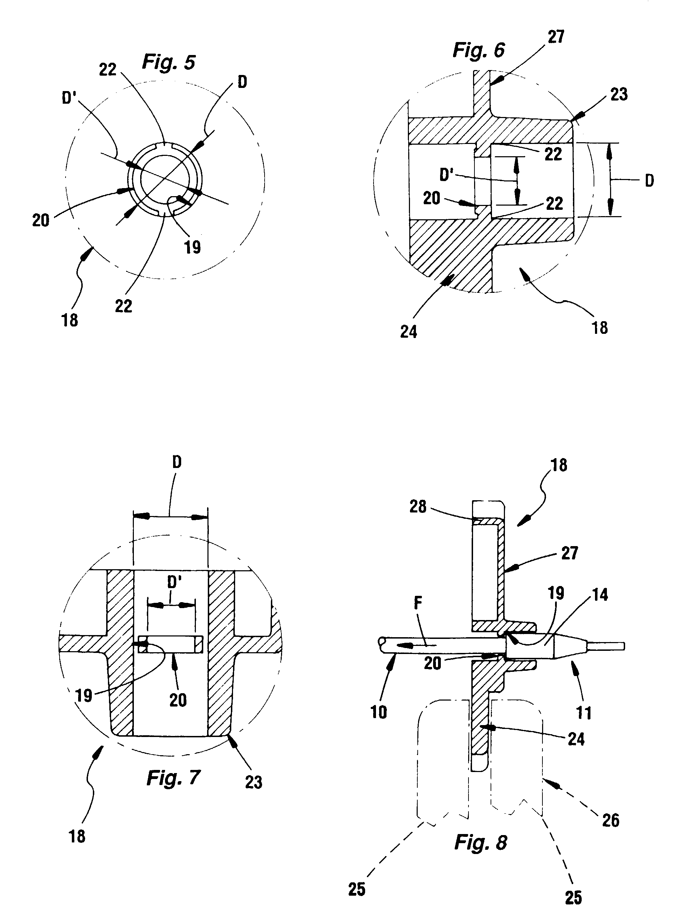

Préférentiellement, et cela est le cas dans la forme de réalisation représentée, le dispositif de test 18 suivant l'invention présente une portion renforcée 24, par laquelle, tel que schématisé en traits interrompus sur la figure 8, il est apte à être saisi entre les mâchoires 25 d'un étau 26 ou d'un quelconque autre organe de maintien de ce genre.

Par exemple, et tel que représenté, cette portion renforcée 24 du dispositif de test 18 forme simplement une portion de plus grande épaisseur de celui-ci.

Par contraste, la portion restante du dispositif de test 18 forme une portion allégée 27 de moindre épaisseur.

Dans la forme de réalisation représentée, cette portion allégée 27 est décalée transversalement par rapport à la portion renforcée 24, et, pour son renfort, elle est bordée, périphériquement, par un rebord 28 dont la tranche est à niveau avec la surface correspondante de la portion renforcée 24.

En pratique, les trous 19 s'étendent à la frontière entre la portion renforcée 24 et la portion allégée 27, et, d'un côté de ces trous 19, les tubes de guidage 23 s'étendent tout entier dans le volume hors tout délimité par le rebord 28 de la portion allégée 27, tandis que, de l'autre côté, ils font saillie sur cette dernière.

En pratique, également, les tubes de guidage 23 ont sensiblement une même longueur de part et d'autre des trous 19.

Lorsque, comme représenté sur la figure 8, le câble électrique 10 est engagé dans un trou 19 par son extrémité opposée à celle à laquelle intervient l'accessoire de câblage 11, cet accessoire de câblage 11 vient buter, par sa partie isolante 14, et, plus précisément, par la tranche de celle-ci, contre l'élément escamotable 20 interférant dans ce trou 19.

Si, tel que schématisé par une flèche sur la figure 8, une force de traction F suffisante est alors exercée sur le câble électrique 10, soit l'accessoire de câblage 11 se détache de ce câble électrique 10 si son sertissage est défectueux, soit, si ce sertissage est satisfaisant, l'élément escamotable 20 cède, en étant arraché de la paroi latérale du trou 19 au niveau des attaches sécables 22 le reliant à celle-ci.

En pratique, le dispositif de test 18 suivant l'invention appartient à un jeu de dispositifs de test 18 différents les uns des autres, les trous 19 de ces dispositifs de test 18, tous identiques entre eux pour un même dispositif de test 18, ayant des diamètres D différents et correspondant à des forces de traction F différentes d'un des dispositifs de test 18 à l'autre, et ces dispositifs de test 18 se distinguant par exemple les uns des autres par des couleurs différentes ou par tout autre moyen de différenciation tel que repère ou autre.

Bien entendu, la présente invention ne se limite pas à la forme de réalisation décrite et représentée, mais englobe toute variante d'exécution et/ou de mise en oeuvre.

## Revendications

1. Dispositif de test pour câble électrique équipé d'un accessoire de câblage à l'une de ses extrémités, caractérisé en ce qu'il comporte au moins un trou (19), qui est propre à un engagement du câble électrique (10) par l'extrémité de celui-ci opposée à celle à laquelle intervient l'accessoire de câblage (11), et dans lequel interfère latéralement au moins un élément escamotable (20) formant butée pour cet accessoire de câblage (11) et susceptible de céder sous une force de traction (F) donnée.

2. Dispositif de test suivant la revendication 1, caractérisé en ce que l'élément escamotable (20) s'étend sur une partie au moins du pourtour du trou (19), et il est relié à la paroi latérale de ce trou (19) par au moins une attache sécable (22).

3. Dispositif de test suivant la revendication 2, caractérisé en ce que l'attache sécable (22) s'étend transversalement par rapport au trou (19).

4. Dispositif de test suivant l'une quelconque des revendications 2, 3, caractérisé en ce que l'élément escamotable (20) est un oeillet qui s'étend tout au long du pourtour du trou (19).

5. Dispositif de test suivant la revendication 4, caractérisé en ce que l'oeillet formant l'élément escamotable (20) a un contour circulaire, comme le trou (19), et il est coaxial de ce trou (19).

6. Dispositif de test suivant l'une quelconque des revendications 4, 5, caractérisé en ce que l'oeillet formant l'élément escamotable (20) s'étend à distance de la paroi latérale du trou (19).

7. Dispositif de test suivant l'une quelconque des revendications 2 à 6, caractérisé en ce que deux attaches sécables (22) sont prévues, en positions diamétralement opposées l'une par rapport à l'autre.

8. Dispositif de test suivant l'une quelconque des revendications 1 à 7, caractérisé en ce que le trou (19) est entouré par un tube de guidage (23) sur l'un au moins de ses côtés.

9. Dispositif de test suivant l'une quelconque des revendications 1 à 8, caractérisé en ce qu'il se présente sous la forme d'une plaquette que le trou (19) qu'il comporte traverse transversalement de part en part.

10. Dispositif de test suivant l'une quelconque des revendications 1 à 9, caractérisé en ce qu'il comporte plusieurs trous (19) de même diamètre (D) et correspondant tous à une même force de traction (F).

11. Dispositif de test suivant la revendication 10, caractérisé en ce que tous les trous (19) qu'il comporte ont un même diamètre (D) et ils correspondent tous à une même force de traction (F).

12. Dispositif de test suivant l'une quelconque des revendications 1 à 11, caractérisé en ce qu'il présente une portion renforcée (24), par laquelle il est apte à être saisi entre les mâchoires (25) d'un étau (26).

13. Dispositif de test suivant l'une quelconque des revendications 1 à 12, caractérisé en ce qu'il appartient à un jeu de dispositifs de test (18) différents les uns des autres.
